Europäisches Patentamt

European Patent Office

Office européen des brevets

(11) Publication number: **0 255 911**
**A2**

# (12) EUROPEAN PATENT APPLICATION

(21) Application number: 87110915.3

(22) Date of filing: 28.07.87

(51) Int. Cl.⁴: **H01L 23/52**

(30) Priority: 05.08.86 US 893411

(43) Date of publication of application:
**17.02.88 Bulletin 88/07**

(84) Designated Contracting States:
**DE FR GB IT**

(71) Applicant: **International Business Machines
Corporation
Old Orchard Road
Armonk, N.Y. 10504(US)**

(72) Inventor: **Ho, Paul Siu-Chung
5 Whippoorwill Lake Rd.
Chappaqua, N.Y. 10514(US)**
Inventor: **Lefakis, Haralambos
737 Pershing Avenue
San Jose, CA 95126-2412(US)**
Inventor: **Smith, David Anthony
Lalli Drive
Katonah, N.Y. 10536(US)**
Inventor: **Tu, King-Ning
44 Whitlaw Close
Chappaqua, N.Y. 10514(US)**

(74) Representative: **Teufel, Fritz, Dipl.-Phys. et al
IBM Deutschland GmbH. Europäische
Patentdienste Postfach 265
D-8000 München 22(DE)**

(54) Metal-dielectric-metal layer structure with low resistance via connections.

(57) A structure is provided suitable for electronic packaging and for integrated microelectronic circuits wherein a discontinuous interface layer (26) is used to insure good electrical conductivity between two metallic layers (M1,M2), while at the same time enhancing adhesion between one of the metallic layers and a dielectric layer (12). In particular, a discontinuous Cr layer (26) deposited onto a substrate comprising a first polyimide portion (12) and a second Cu (18) portion will ensure good adhesion between a copper layer (22) and the polyimide, while still maintaining low electrical resistance in the copper-copper electrical contact region (14).

FIG.2

EP 0 255 911 A2

## METAL-DIELECTRIC-METAL LAYER STRUCTURE WITH LOW RESISTANCE VIA CONNECTIONS

This invention relates to a metal-dielectric-metal layer structure employed for example in multilayer integrated circuit structures such as the metallized ceramic polyimide (MCP) structure, and more particularly to a structure in which a first metallization level M1 has thereon a dielectric layer having via holes therein, the structure further including a second metal level M2 which extends through the via holes to electrically contact metal level M1.

In the microelectronic industry, it is common to have two metal layers separated by a dielectric layer, where the metal layers electrically contact one another through via holes in the dielectric. An example of such a structure is a multilayer integrated circuit substrate such as a metallized ceramic polyamide structure (MCP). This structure comprises a ceramic substrate on which is deposited a first layer M1 of a metal in which printed circuitry is formed, a layer of polyimide dielectric material, and a second deposited metal layer M2 in which printed circuitry is also formed. Via holes are formed in polyimide prior to the deposition of the M2 layer, the via holes extending down to the M1 layer. When the M2 metal layer is deposited, a portion of it will electrically connect to the M1 metal layer through the via holes. Such a structure is described in U.S. Patent 4,386,116, assigned to the present assignee.

It is often the situation that the metallization levels M1 and M2 are comprised of a plurality of metal layers. For example, U.S. Patent 4,386,116 describes the use of different combinations of Cu and Cr in the metallurgy of levels M1 and M2. Whatever the metallurgy used for levels M1 and M2, it is necessary that the M2 metal adhere well to the dielectric layer separating levels M1 and M2, and also that the M2 layer makes good electrical contact with the M1 metal in the via holes. These problems are described in the aforementioned U.S. Patent, in which the solution was to directly deposit Cu as a first layer in level M2. As described therein, Cu will sufficiently adhere to the polyimide dielectric layer and also will make good contact to the Cu layer in the MI metallurgy, if the temperature of the substrate is between about 360-380°C during evaporation of M2.

Another reference generally relating to the problem of adhesion between a deposited metal layer and an underlying dielectric layer is U.S. Patent 4,404,235. In this reference, islands of W or Mo are formed on the dielectric layer in order to structurally roughen the dielectric surface. This surface roughening occurs without damaging the dielectric layer and improves the adhesion of a subsequently deposited metal layer. To be effective, the islands used in the structure for aiding adhesion have to be rather large, being about 0.1-1.0 micrometers in size and covering approximately 10-90% of the area of the dielectric surface.

In applicants' experiments, it has been found that, while a metal such as Cr can be used to promote adhesion between an overlying Cu layer and a dielectric such as polyimide, the presence of a Cr interface layer of about 1000 angstroms in thickness in the area of the via con tact is deleterious. In this area, the electrical resistance must be extremely small, and the presence of an oxide layer such as Cr oxide must be avoided. The increase in the electrical resistance of the via is due to the presence of a continuous Cr oxide layer which is formed during Cr evaporation or during later processing steps. The thickness and the continuity of the oxide layer, hence the resistance of the via, depends on the Cr layer thickness. It has been found that a Cr layer of 1000 angstroms thickness would usually produce a continuous oxide layer at the via contact. For this reason, a continuously thick interface Cr layer is not desired in via contact areas, even though it is preferable on the dielectric surface since it can improve adhesion between the M2 layer and the underlying dielectric.

In order to solve the above-mentioned problems, applicants have discovered that a discontinuous layer of metal can be deposited both on the dielectric layer and on the exposed portion (in the via hole) of the M1 layer, without impeding the electrical continuity in the via region and at the same time enhancing the adhesion of the M2 layer to the dielectric. The discontinuous metal layer has thickness chosen in accordance with the na ture of the exposed metal in the M1 level and its surface roughness, and can vary over a wide range, as will be explained later. In contrast with the technique of U.S. patent 4,404,235, where the W and Mo islands are used to roughen a dielectric layer surface, the important surface in the present invention is the exposed M1 surface, and the dielectric surface is of secondary consideration. As an example of the significance of this difference, if islands of the thickness designated in U.S. 4,404,235 (0.1-1.0 micrometers) were formed on an exposed Cu layer of the type used in an M1 metallization level, it is possible that the deposited film would be continuous and would cause the presence of a continuous oxide layer - a result directly opposite to that required for applicants' invention.

Another distraction of the present invention over that shown in U.S. Patent 4,404,235 relates to the presence of the discontinuous metal layer both over the dielectric layer and in the via contact area in applicants' invention. This contrasts with the invention in U.S. Patent 4,404,235, where the W and Mo islands are used only over the dielectric layer in order to promote metal-dielectric adhesion.

Still another distinction over the aforementioned U.S. Patent 4,404,235 relates to the deposition temperature for forming the W and Mo islands in that reference. These islands are formed at deposition temperatures of about 500-600°C in a gaseous environment. However, when the temperatures of deposition are that high, they will exceed the curing temperature for polyimide, which is about 300-400°C this way degrade the properties of the polyimide layer. In addition, the Cr layer could undergo oxidation to produce a high resistance contact in the via area.

As mentioned earlier, interface layers for the improvement of adhesion are well known in the art, and have been applied to metal-dielectric film composite. For example, thick Cr layers have been used to improve adhesion between Cu and polyimide. However, while improved adhesion results, poor conductivity occurs in the area of the via holes if the Cr layer is present. The thick Cr layer would be subject to oxidation and the overall contact resistance would be increased too greatly.

Accordingly, it is the object of the present invention to provide an improved metal-dieletric-metallayer structure in which good electrical contacts are produced in vias connecting the metal layers, and in which the top metal layer adheres very well to the dielectric layer.

An improved multilayer structure is provided generally comprising a substrate, a first level M1 of metallization located on the substrate, a dielectric layer located on M1, there being via holes in the dielectric layer exposing M1, and a second level M2 of metal deposited on the dielectric layer and making electrical contact with level M1 through the via hole. In order to enhance adhesion between M2 and the dielectric layer without adversely affecting the electrical contact between M1 and M2, a thin discontinuous metal layer is deposited over the entire surface of the dielectric layer and the via hole areas prior to deposition of the metal layer M2. This discontinuous layer provides improved adhesion sites to insure good adhesion between M2 and the dielectric layer and, because it is thin and discontinuous, does not interfere with the electrical conductivity of the M1-M2 contact. That is, it provides enough areas for M1 to directly contact M2 through the discontinuous regions.

It is an advantage of the present invention to provide an interface layer which can be used between two metal layers M1 and M2 without adversely affecting the electrical conductivity in the area of M1-M2 contact, and which also enhances the adhesion between one of the metal layers and a dielectric material.

Examples of the metal layers M1 and M2 include any type of good electrical conductor such as Cu, Al, Au, Pd, Pt, and Ni. Metal layers M1 and M2 can also be composites of multiple layers comprised of different metals, such as Cu and Cr layers, Ti, and Al layers, and Cr and Al layers.

The discontinuous interface layer is a metal layer of a thickness that is dependent on several factors and ex hibits discontinuously in a lateral direction. Materials which are suitable for the discontinuous interface layer include Cr, Ti, Cr-Ti, Ti-Al, Al, Ni, and refractory metals such as Va, Ta, Nb, Zr, and Mo.

Examples of the dielectric layer separating metals M1 and M2 include polymers such as polyimide, plastics such as epoxy, insulators such as quartz and $SiO_2$, glass, ceramics, etc.

In the following description of an embodiment of the invention, reference is made to drawings, wherein:

FIG. 1 is a side elevational view showing a conductive via connection between first (M1) and second (M2) layers of metallurgy in a multilayer integrated circuit structure, of the type known in the prior art.

FIG. 2 is a side elevational view of the same type of structure as that illustrated in FIG. 1, except that a discontinuous metallic layer is deposited prior to de position of the second (M2) layer of metallurgy. The structure of FIG. 2 was prepared in accordance with the present invention.

FIG. 3 is a plot of signal intensity versus frequency change (related to the amount of Cr coverage) for Cr deposited on two substrates: Cu-coated silicon (smooth) and Cu-coated ceramic (rough). This plot indicates the amount of coverage of the Cr layer on each substrate and can be used to determine the thickness of the Cr deposit that is required to produce a discontinuous layer of Cr. This gives an example of a measurement for the thickness of an overlayer to produce a desired percentage of coverage for a particular substrate.

An embodiment of the invention will be described with reference to multilayer integrated circuit structures.

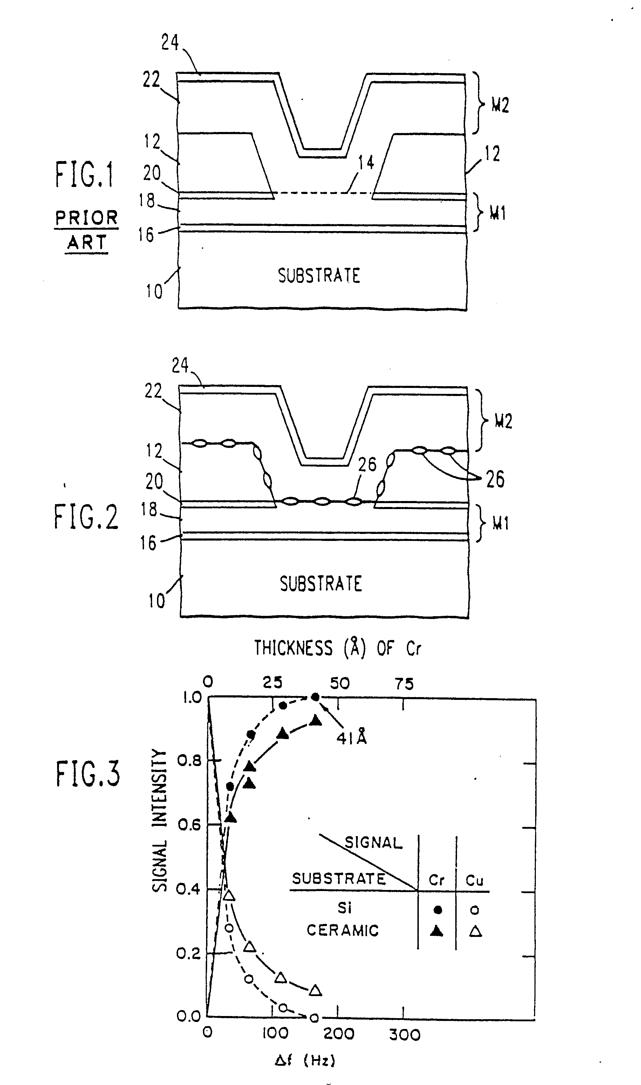

FIG. 1 is a typical structure illustrating a conductive via interconnection between two levels of metallurgy, such as the type commonly found in multilayer integrated circuit technology. This structure is comprised of a substrate 10, a first level M1 of metallurgy which is generally patterned to provide circuit lines, a layer 12 of dielectric material such as polyimide, and a sec ond level M2 of metallurgy. A via hole has been formed in dielectric layer 12 so that metal levels M1 and M2 contact one another along an interface as indicated by dashed line 14. Level M2 is also usually patterned to provide additional circuit lines.

In a well known structure of the type illustrated in FIG. 1, metallization levels M1 and M2 can be comprised of multilayers of metals. For example, level M1 can be comprised of a first Cr layer 16, a second Cu layer 18, and a third Cr layer 20. Representative thicknesses for the layers 16, 18 and 20 are 800 angstroms, 4.3 micrometers, and 800 angstroms, respectively. The substrate 10 is any type of material including insulators such as ceramics, glass, and polymers such as epoxies. It could also be comprised of other materials such as microelectronics built on semiconductors.

The level M1 of metallurgy is generally deposited on substrate 10 by evaporation. For example, in the situation where M1 is comprised of Cr-Cu-Cr, and the substrate 10 is a ceramic, level M1 is evaporated on a raw ceramic substrate at a substrate temperature of about 280°C, using commercially available equipment. In this equipment, a pool of copper is contained and an electron beam is used to fire and melt the copper, causing it to evaporate upward onto the substrate. The chrome in solid form is turned into a vapor by heating with a resistance boat and evaporated upward onto the substrate. The bottom Cr layer 10 is given a thickness of 800 angstroms deposited at a rate of 6-angstroms per second. CU layer 18 is given a thickness of 43,000 angstroms and is deposited at the rate of 150 angstroms per second. The top Cr layer 20 is given a thickness of 800 angstroms and is deposited at a rate of about 8-10 angstroms per second.

The M1 layer is then circuitized through the use of conventional lithographic steps in order to etch circuits in the M1 metallurgy.

Dielectric layer 12 can be any type of insulating layer including polyimides, quartz, $SiO_2$, other polyimides such as epoxies, glass or ceramics. Polyimide is a particularly suitable material based on its electrical properties and its relative chemical inertness. The polyimide layer 12 can easily be applied to the surface of M1 by spraying, and is partially cured at 90° to remove excess solvent. After this, a resist layer is applied, exposed, and developed so that the via sites are exposed. The polyimide can be etched in a KOH solution for a brief cycle of about 40 seconds. The polyimide is then given another cure at 210°C in order to stabilize the material.

Polyimide 12 is again etched in KOH for a longer cycle of around 3 minutes and the resist layer is stripped. A via at this point in time is a hole in the polyimide down to the M1 circuitry. The polyimide then undergoes the final curing cycle at 360°C, in a nitrogen flow furnace. After this, the polyimide can no longer be etched. This final curing will cause exposed metal in the vias to be oxidized. This oxide is removed by a series of cleaning steps.

The top Cr layer 20 of the M1 layer is then etched to expose the copper layer 18 at the base of the via holes. A bright-dip operation can be carried out to remove oxidation of copper in the vias by immersion in 10% sulphuric acid for 1 minute, followed by ultrasonic agitation, rinsing in deionized water, and alcohol drying.

At this time, deposition of the top metallization level M2 can occur. Level M2 is generally comprised of a good conductor including metals such as Cu, Al, Au, Ni, and combinations or alloys of these metals. In a particular example, illustrated in FIG. 1, level M2 is comprised of a first Cu layer 22 and a second Cr layer 24.

In the example illustrated in FIG. 1, where level M2 is comprised of Cu-Cr layers, evaporation can be used to deposit the M2 layer. The M2 layer of Cu-Cr is evaporated in the same manner as was M1, except that a substrate temperature of 360-380°C is used. Cu layer 22 is deposited to a thickness of 80,000 angstroms, at a rate of 150 angstroms per second. Cr layer 24 is deposited to a thickness of 800 angstroms, at a rate of about 8 angstroms per second. The total cycle time is approximately two hours.

After deposition of the M2 level, this level is also circuitized through the use of conventional lithography in order to etch circuits in the M2 metallurgy. The structure is then ready for subsequent conventional pinning and tinning processing and electrical testing of M2 for electrical shorts/open and resistance. Via resistance can be measured on sample vias by a 4-point probe method.

In the structure of FIG. 1, a Cr interface layer was not used over the polyimide layer 12, even though a Cr layer would improve the adhesion of Cu layer 22 to the underlying polyimide layer 12. This is because the presence of a thin Cr layer in the via area would cause adverse affects to the electrical conductivity in the via areas. In order to solve this problem, applicants have discovered that a thin metal interface layer can be used over the entire substrate comprised of dielectric layer 12 and exposed metal layer M1, prior to deposition of the M2 level, if a discontinuous metal interface layer is used. This discontinuous metal layer enhances adhesion between M2 and the dielectric layer 12, but does not adversely affect electrical conductivity in the via regions.

FIG. 2 shows a sample structure similar to that of FIG. 1, except that the present invention has been utilized to provide enhanced adhesion and electrical conductivity. In FIG. 2, the same reference numerals will be used as were used in FIG. 1, in order to illustrate functional and/or compositional similarity of various components. The difference over FIG. 1 is the provision of the discontinuous metal interface layer 26 which is formed on the surface of the dielectric 12 and in the via areas prior to deposition of the second level of metallurgy M2. The discontinuous interface layer 26 is comprised of a metal including Cr, Ti, Cr-Ti, Ti-Al, Al, and refractory metals such as Va, Ta, Nb, Zr, and Mo. For the M1 and M2 metallurgies illustrated in FIG. 1, a particularly advantageous choice for the discontinuous interface layer is Cr.

The interface layer 26 must be discontinuous in the region of the via where good conductivity electrical contact must be made between metal levels M1 and M2. In regions where the interface layer 26 is in contact with dielectric layer 12, however, it is not necessary that the interface layer 26 be discontinuous. In fact, a continuous interface layer in this region would provide good adhesion between M2 an layer 12.

Because the interface layer 26 is advantageously deposited in a single step across the entire substrate comprising the dielectric layer 12 and the exposed via area, interface layer 26 is deposited as a discontinuous layer. This ensures that the contact resistance in the via area is sufficiently small and that enough of the interface layer is present on the dielectric layer 12 to insure good adhesion between M2 and the dielectric layer. Thus, a single deposition step can be used to provide an interface layer 26 that has suffucient properties for both purposes: enhancing adhesion and not adversely increasing M1-M2 electrical contact resistance.

In the practice of this invention, the discontinuity of layer 26 is the most important factor. The thickness $t_m$ below which the interface layer will be discontinuous varies depending upon the nature of the deposited metal and the nature of the substrate on which the interface layer is deposited, i.e., the surface roughness of the substrate, and on other parameters relating to the deposition technique. These other parameters include the deposition rate, substrate temperature, and the atmosphere in which the deposition occurs. Thus, as will be more apparent later, the thickness of the interface layer 26 in order to insure that it be discontinuous in the via contact area can vary over a wide range of, for example, of the order of 20 angstroms or less to several hundred angstroms or even more than a thousand angstroms.

As noted, interface layer 26 must be discontinuous in via contact areas in order to insure good electrical conductivity between M1 and M2. In the example of a Cu-Cu contact of the type used in several packaging arrangements, the discontinuous Cr interface layer can have a coverage up to approximately 95% of the total via contact area. Of course, the amount of coverage of the discontinuous film in the via area is chosen in accordance with the limits of electrical resistance in the particular design. Thus, a preferred coverage of a Cr interface area in this particular packaging arrangement is approximately 50-70%.

On the lower end of the Cr interface layer coverage, a minimum coverage of approximately 10% will provide good adhesion between M2 and a polyimide dielectric layer. As noted previously, the interface layer over the dielectric layer is used to enhance adhesion between M2 and the dielectric layer, and the coverage in this area of the substrate can be 100% to provide maximum adhesion. It has been found that a discontinuous Cr interface layer in a structure using Cu-Cu electrical contacts and a polyimide dielectric layer 12 having coverages 50-90% provide very adequate results.

The following explanation will describe suitable deposition processes for forming the discontinuous interface layer 26, and for determining the amount and time of deposition necessary to provide a discontinuous interface layer having a desired percentage of coverage of the substrate. These techniques can be used regardless of the smoothness or roughness of the substrate and the nature (i.e., composition) of the material comprising the substrate.

Deposition of Interface Layer 26

Interface layer 26 can be fabricated by a number of well known techniques. Two of these are the following: flash evaporation and electron beam evaporation or sputtering, in combination with a thickness monitor. Flash evaporation is a process in which a preweighed amount of charge material is placed in a boat and is physically vapor deposited onto a substrate in a very rapid time. Generally the time of evaporation is less than 1 minute, and typically is several seconds. In this technique, the source material is rapidly heated by a variety of techniques including resistive heating. Commercial evaporators are used for this purpose, and the use of a predetermined amount of source material will provide a discontinuous film on a substrate located at a fixed distance of the order of 18 - 30 cm (7 - 12 inches) from the source material.

In the second mode of deposition, conventional evaporation or sputtering can be undertaken in an apparatus incorporating a thickness monitor. Physical evaporation can occur by the use of an electron beam to vaporize source materials which then deposit on a substrate, or by sputtering in which inert gas ions and atoms are used to discharge source material for travel to and deposition onto the substrate. The apparatus will utilize a shutter to stop deposition onto the substrate after the thickness monitor indicates the deposition of a certain thickness known beforehand to provide a discontinuous film having the desired percentage of coverage of the substrate. Any well known type of thickness monitor can be used, including water-cooled quartz crystal oscillators. These monitors indicate the thickness of a deposited film by a change in resonance frequency, and the frequency change of the crystal transducer is calibrated in accordance with the thickness of the deposited film. When a predetermined thickness is measured by the monitor, the shutters are closed to prevent further deposition onto the substrate. At that thickness, a discontinuous interface layer having a desired percentage of substrate coverage will be obtained.

Determination of Thickness $t_m$ to Ensure a Discontinuous Film

As noted previously, it is necessary to either know the amount of source material to be used in flash evaporation, or the thickness of the deposited interface layer in order to ensure that a discontinuous interface layer is obtained. These quantities are determined beforehand for each set of substrates and, once determined, can be repeated for each subsequent deposition on the same or similar substrates. For example, if a via contact is to be made between Cu layers in M1 and M2, a Cr interface layer can be used where the deposition process will have all of its parameters adjusted for the Cu substrate.

In order to determine the desired percentage of coverage of the discontinuous film in the via area, Auger electron spectroscopy (AES) is used. In this technique, an evaporator is installed inside an AES chamber which includes shutters, a thickness monitoring device, a heated specimen holder, and a facility for introducing a special atmosphere. Auger signals of the substrate and/or deposited film are monitored along with the deposit coverage. The rate of signal change with coverage of a deposited film is a function of deposited film thickness, surface and interfacial energies of deposited film, substrate, and deposited film/substrate respectively, evaporation characteristics including deposition rate, pressure, and composition of the atmosphere, substrate temperature, and the surface roughness and chemistry of the substrate.

As the thickness of the deposited film increases, the signal due to the deposited film will increase while the signal due to the substrate will decrease. Where these signals measure equal amounts of the deposited material and the substrate 50% coverage is provided and, as the deposition thereafter increases, the percentage of coverage of the substrate will increase. Since the thickness monitor indicates the thickness of the deposited interface layer, the percentage of coverage as a function of the thickness of the interface layer is known. This technique automatically takes into account the various parameters relating to the substrate roughness and chemistry and the parameters relating to the deposition process. Once the thickness is known in terms of the amount of substrate coverage desired, the discontinuous interface layer can be provided very easily under similar deposition conditions, as described hereinabove.

In order to clarify the results of the Auger spectroscopy analysis which enables one to determine the process parameters necessary to provide a discontinuous interface layer having the desired degree of coverage, reference will be made to an actual example as depicted in FIG. 3. This figure plots the Auger signal intensity versus crystal monitor output and thickness of the depositing film. In this example, two substrates are used: a Cu-coated Si substrate and a Cu-coated ceramic substrate. The Cu-coated Si substrate is much smoother than the Cu-coated ceramic substrate. The interface layer that is deposited is a Cr layer. The bottom horizontal axis labelled $\Delta f(Hz)$ is the output of the thickness monitor, while the top horizontal axis is the corresponding thickness in angstroms of the Cr layer that is deposited.

Both Cu-coated substrates were sputter cleaned with $Ar^+$ before the onset of evaporation, and evaporation onto both substrates was made at room temperature. As expected, the more smooth Cu-coated Si substrate will be completely covered with Cr more quickly than will be the rough Cu-coated ceramic substrate. From a review of FIG. 3, it is seen that about 20 angstroms of Cr deposited on the Cu-coated silicon substrate will provide about 90% coverage of this substrate, while 40 angstroms twice the same 90% coverage of the Cu-coated ceramic substrate. This is because the Cu-coated ceramic substrate is rougher than the Cu-coated silicon substrate.

In FIG. 3, the darkened data points correspond to the thicknesses of the deposited Cr film, while the hollow data points correspond to the Auger signals received from the Cu-coated substrates. The Auger signals from the depositing Cr increase in intensity as the thickness of the Cr layer increases, while those corresponding to the signal received from the Cu substrate decrease in time as the Cr thickness increases. Using known techniques, Auger signals are converted to the amount of the material (Cr, Cu). For any given substrate, the point where the corresponding curves of Cr and Cu intersect is the point where 50% coverage of the substrate is provided. That is, the intersection point of these curves corresponds to equal signals being received from the underlying Cu and from the depositing Cr. Thus, a signal intensity of 0.2 corresponds to 80% copper and 20% Cr, while the signal intensity of 0.8 corresponds to 80% Cr and 20% Cu.

As noted previously, the thickness of the deposited interface layer 26 necessary to provide a desired coverage of the substrate will vary depending upon the characteristics of the substrate and the deposition conditions. Circuit technology is in general heading towards the use of smoother substrates, which means that the thickness $t_m$ of the interface layer 26 will decrease in order to provide discontinuous films having a constant percentage of coverage. However, it is possible to vary the deposition parameters to provide a constant level of coverage at different thicknesses. For example, parameters such as evaporation rate, substrate temperature, and gas atmosphere can be varied in order to change the amount of coverage on the substrate with the same thickness of the deposited film. For example, as the percentage of oxygen or water vapor in the deposition atmosphere increases, the surface mobility of the depositing species will decrease, and consequently a lesser thickness of deposited film will be required to provide the same percentage coverage of the substrate.

As another example, if the evaporation rate is decreased and the substrate temperature is increased, this will allow depositing metal atoms to move on the surface of the substrate. Thus, a greater amount of the deposited materials will be required to provide the same percentage coverage that would be obtained at a lower substrate temperature. For example, if the substrate temperature is increased from 100°C to 300°C it may be necessary to deposit 50 angstroms of Cr to rather than 20 angstroms at 100°C, in order to provide the same percentage of substrate coverage. Since it is in general easier to control the deposition of 50 angstroms in contrast with 20 angstroms, these techniques can be used for processing control. This will be particularly useful for depositing satisfactory discontinuous interface layers on substrates which are exceptionally smooth.

While specific examples have been described, it will be apparent that the technique described hereinabove with respect to FIG. 3 can be used to determine appropriate film thicknesses for interface layers on any type of substrate and with any set of deposition conditions.

In this manner, suitable process parameters can be defined to enable the implementation of the present invention in any type of packaging arrangement.

## Claims

1. A metal-dielectric-metal structure with an interface layer between at least one metal layer and the dielectric, the interface layer extending into a contact area of the metal layers (18,22) in a via hole of the dieelectric (12),
characterized in
that the interface layer (26) is laterally discontinuous in the contact area of the metal layers in the via hole.

2. The structure of claim 1, wherein approximately 10-95 % of the metal layer exposed in the contact area of the via hole are covered by the discontinuous interface layer.

3. The structure of one of the preceeding claims, wherein the interface layer is laterally continuous between at least one metal layer and the dielectric.

4. The structure of one or more of the preceeding claims, wherein the composition of the metal layers comprises at least one of the metals Cu, Al, Au, Pd, Pt, Ni, Cr, Ti.

5. The structure of one or more of the preceeding claims, wherein the composition of the at least one interface layer comprises at least one of the metals Cr, Ti, Al, Ni, Va, Ta, Nb, Zr, Mo.

6. The structure of one or more of the preceeding claims, wherein the composition of the at least one dielectric layer includes polymers such as polyimide, plastics such as epoxy, insulators such as $SiO_2$, glass, ceramics.

7. Use of the metal-dielectric-metal layer structure in accordance with one or more of the preceeding claims in a multilayer integrated circuit structure.

FIG.1

PRIOR ART

FIG.2

FIG.3